# FASCICULE DE BREVET EUROPEEN

(11) **EP 1 813 017 B1**
(45) Date de publication et mention de la délivrance du brevet: **23.01.2008**
(21) Numéro de dépôt: 05815184.6
(22) Date de dépôt: 04.11.2005
(51) Int. Cl.: H03L 7/089

(54) **DISPOSITIF DE COMPENSATION DE L'ERREUR DE PHASE STATIQUE DANS UN SYSTÈME À BOUCLE DE VERROUILLAGE DE PHASE À STRUCTURE SYMÉTRIQUE**
EINRICHTUNG ZUR KOMPENSATION DES STATISCHEN PHASENFEHLERS IN EINEM PHASENREGELKREISSYSTEM MIT SYMMETRISCHER STRUKTUR
DEVICE FOR STATIC PHASE ERROR COMPENSATION IN A PHASE-LOCK LOOP SYSTEM WITH A SYMMETRICAL STRUCTURE

(30) Priorité: 15.11.2004 FR 0412084
(43) Date de publication de la demande: 01.08.2007
(73) Titulaire: COMMISSARIAT A L'ENERGIE ATOMIQUE, 75015 Paris (FR)
(72) Inventeur: MASSON, Gilles, F-38140 Renage (FR)
(74) Mandataire: Bonnans, Arnaud
(86) Numéro de dépôt international: PCT/FR2005/002756
(87) Numéro de publication internationale: WO 2006/051196

(56) Documents cités:
- EP-A- 0 718 978
- US-A- 5 477 177
- US-A- 6 111 470
- GU-YEON WEI ET AL: "A 500MHz MP/DLL clock generator for a 5gb/s backplane transceiver in 0.25/spl mu/m CMOS" SOLID-STATE CIRCUITS CONFERENCE, 2003. DIGEST OF TECHNICAL PAPERS. ISSCC. 2003 IEEE INTERNATIONAL SAN FRANCISCO, CA, USA 9-13 FEB. 2003, PISCATAWAY, NJ, USA,IEEE, US, 9 février 2003 (2003-02-09), pages 1-8, XP010661496 ISBN: 0-7803-7707-9 cité dans la demande

## Description

La présente invention se rapporte à la compensation de l'erreur de phase statique dans un système à boucle de verrouillage de phase à structure symétrique.

Elle trouve une application dans les circuits électroniques devant produire des horloges déphasées avec une grande précision, à partir d'une horloge de référence très haute fréquence, typiquement supérieure à 1 GHz.

Ainsi, elle trouve une application dans les systèmes à boucle de verrouillage de phase, appelés encore « PLL » pour *Phase Locked Loop* ou « DLL », pour *Delay Locked Loop,* dans lesquels il est nécessaire de convertir un décalage temporel en une tension proportionnelle avec une grande précision.

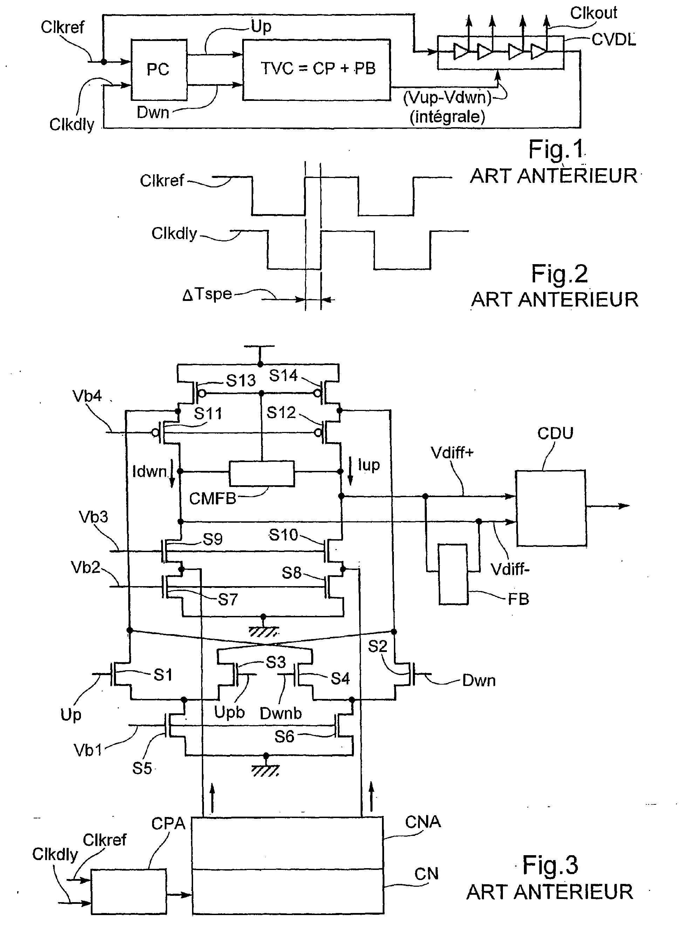

En référence à la **figure 1**, on a décrit l'architecture d'un système à boucle de verrouillage de phase de l'art antérieur. Un tel système à boucle de verrouillage de phase comprend généralement :
- un comparateur de phase, PC ;
- un convertisseur temps-tension, TVC, équipé d'une pompe de charge, CP et d'un filtre passe-bas PB ; et
- une ligne à retards commandés en tension, CVDL.

Les signaux d'horloge Clkout de la ligne à retards commandés en tension CVDL, sont des signaux d'horloge de même fréquence que le signal d'horloge Clkref, mais déphasés entres eux d'une durée devant être contrôlée avec une grande précision.

Le comparateur de phase PC compare le signal d'horloge de référence Clkref et le dernier signal d'horloge Clkdly de la ligne à retards. Les deux signaux d'horloge Clkref et Clkdly doivent être en phase quand la boucle est verrouillée.

En pratique, le comparateur de phase PC délivre deux signaux logiques Up et Dwn, qui sont l'image du décalage de phase entre les deux signaux d'horloge Clkref et Clkdly que l'on veut synchroniser parfaitement. Lorsque les deux signaux d'horloge ne sont pas encore synchronisés, les signaux logiques Up et Dwn ont des durées différentes.

C'est cette différence de durée que l'on veut convertir en une tension proportionnelle, puis intégrée dans le temps, afin de corriger l'écart par l'intermédiaire d'un boucle de contre réaction.

Ainsi, la différence de durée entre les signaux Up et Dwn est convertie en une tension proportionnelle intégrée Vup-Vdwn qui commande la ligne à retards CVDL.

En référence à la **figure 2**, on a décrit l'erreur de phase statique dans le système à boucle de verrouillage de phase de la **figure 1**.

L'erreur de phase statique ΔTspe se mesure en mode verrouillé et correspond à un décalage constant entres les signaux d'horloge d'entrée du comparateur de phase PC. Elle est la somme de toutes les erreurs de désappariement présentes dans le comparateur de phase PC et le bloc de conversion temps-tension TVC.

L'erreur de phase statique agit directement sur le décalage des signaux d'horloge déphasés et constitue la principale source d'erreur dans un système à boucle de verrouillage de phase.

Parmi les systèmes à boucle de verrouillage de phase de l'art antérieur, on connaît des architectures particulières dites « à structure symétrique », c'est-à-dire fondées sur une symétrie dans la conversion temps-tension pour les voies Up et Dwn pour toutes les opérations réalisées en haute fréquence.

On sait que de telles architectures réduisent structurellement l'erreur de phase statique.

Par exemple, une architecture symétrique connue est basée sur une pompe de charge différentielle, telle que celle décrite dans le document de Gu-Yeon Wei et al. et intitulé « A 500MHz MP/DLL Clock Generator for 5Gb/s Backplane Transceiver in 0.25µm CMOS», ISCC 2003.

Une autre structure de conversion temps-tension symétrique est décrite dans la demande de brevet déposée le même jour par le Demandeur et intitulée « Circuit de conversion temps-tension symétrique».

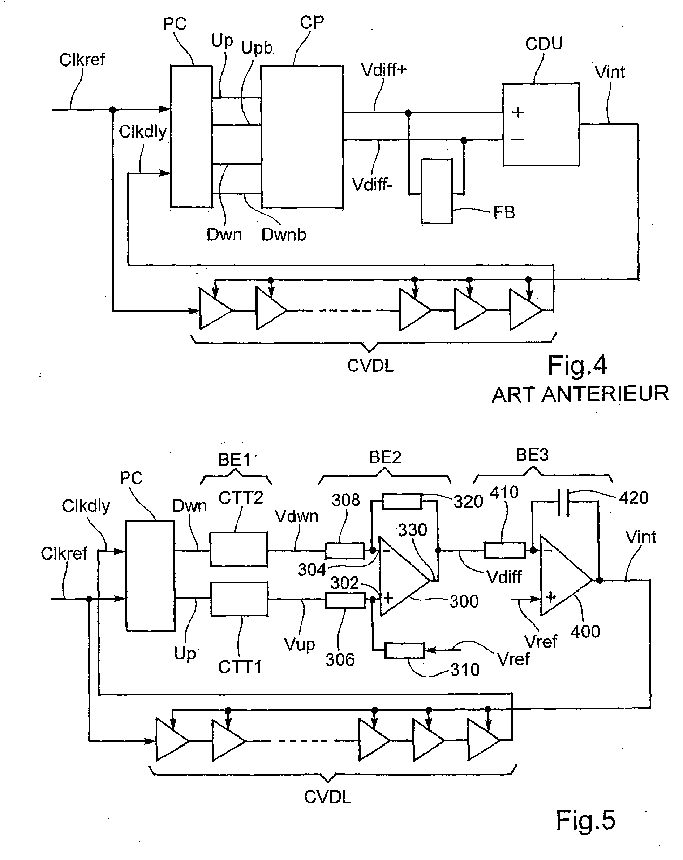

En référence aux **figures 3 et 4**, on a décrit l'architecture symétrique basée sur une telle pompe de charge CP différentielle. En pratique, la pompe de charge CP comprend quatre interrupteurs de commande S1 à S4, S1 et S2 ayant pour entrée de commande respectivement les signaux Up et Dwn et S3 et S4 ayant pour entrée de commande respectivement les complémentaires Upb et Ddwnb des signaux Up et Dwn.

Le circuit comprend en outre huit transistors de passage de courant S5 à S12. Les transistors de passage S5 et S6 sont des moyens qui regulent le passage d'un courant en fonction de la tension de polarisation Vb1. Les transistors de passage S7 et S8 sont commandés par une tension de polarisation Vb2. Les transistors de passage S9 et S10 sont commandés par une tension de polarisation Vb3. Les transistors de passage S11 et S12 sont commandés par une tension de polarisation Vb4.

Des transistors S13 et S14 sont pilotés par un bloc, appelé CMFB pour *Common Mode FeedBack.* Le bloc CMFB permet de contrôler le mode commun en sortie, c'est-à-dire le niveau moyen des tensions Vdiff+ et Vdiff-.

Lorsque les signaux Up et Dwn sont opposés, les courants lup et Idwn circulent dans le filtre de boucle FB et sont intégrés pour produire une tension différentielle (Vdiff+ - Vdiff-). Cette tension différentielle est convertie en un signal unipolaire Vint par un convertisseur CDU pour commander une ligne à retards CVDL.

La structure de cette architecture différentielle est dite symétrique dans la mesure où les courants lup et Idwn sont générés à partir de transistors de dimensions et de types identiques. De même, les transistors S5 à S12 sont identiques pour les signaux Up et Dwn.

Pour compenser l'erreur de phase statique, trois blocs ont été ajoutés.

Un comparateur de phase additionnel CPA est utilisé pour détecter l'erreur de phase statique en effectuant la comparaison entre les horloges Clkref et Clkdly.

Les informations Up et Dwn issues du détecteur de phase CPA sont intégrées dans un compteur numérique CN.

Un convertisseur numérique-analogique CNA à sortie en courant est utilisé pour ajuster les courants lup et Idwn et compenser le désappariement.

La technique de compensation proposée dans cette architecture à pompe de charge différentielle permet de réduire l'erreur de phase statique des blocs principaux, mais ajoute une source d'erreur à cause des désappariements présents dans le comparateur de phase supplémentaire CPA.

La présente invention remédie à ces inconvénients.

Elle porte sur un dispositif à boucle de verrouillage de phase à structure symétrique comprenant un comparateur de phase possédant des première et seconde entrées recevant respectivement des premier et second signaux d'horloge et des première et seconde sorties délivrant respectivement des premier et second signaux logiques, un bloc de conversion temps-tension symétrique possédant au moins des première et seconde entrées recevant respectivement les premier et second signaux logiques et des première et seconde sorties délivrant respectivement une tension fonction des premier et/ou second signaux logiques, et un bloc de traitement en tension possédant des première et seconde entrées recevant respectivement des première et seconde tensions à traiter.

Selon une définition générale de l'invention, le dispositif comprend en outre des première et seconde paires de commutateurs à ouverture/fermeture alternée selon des première et seconde phases, intercalées entre les première et seconde sorties du bloc de conversion temps-tension symétrique d'une part et les première et seconde entrées du bloc de traitement en tension d'autre part, des troisième et quatrième paires de commutateurs à ouverture/fermeture alternée selon les première et seconde phases, disposées en amont des première et seconde entrées du comparateur de phase, et des moyens de commande propres à commander l'ouverture/fermeture des première à quatrième paires de commutateurs de manière à relier pendant la première phase le premier signal d'horloge sur la première entrée du comparateur et le second signal d'horloge sur la seconde entrée du comparateur et la première sortie du bloc de conversion à la seconde entrée du bloc de traitement et la seconde sortie du bloc de conversion à la première entrée du bloc de traitement et pendant la seconde phase le premier signal d'horloge sur la seconde entrée du comparateur et le second signal d'horloge sur la première entrée du comparateur et la première sortie du bloc de conversion à la première entrée du bloc de traitement et la seconde sortie du bloc de conversion à la seconde entrée du bloc de traitement.

Une telle structure permet de compenser l'erreur de phase statique présente dans le comparateur de phase et bloc de conversion temps-tension symétrique, de manière continue à basse fréquence et sans ajouter de composants susceptibles d'introduire d'autres erreurs.

Selon une réalisation, le bloc de conversion temps-tension comprend deux convertisseurs temps-tension élémentaires, structurellement identiques l'un par rapport à l'autre, et possédant chacun une entrée recevant un signal de commande logique respectif et une sortie délivrant une tension représentative de la durée du signal de commande logique correspondant.

Selon une autre réalisation, le bloc de traitement en tension comprend un bloc différentiateur possédant des entrées positive et négative reliées chacune à une sortie d'un convertisseur élémentaire associé via les première et seconde paires de commutateurs et une sortie délivrant un signal représentatif de la différence de tension entre les deux signaux de commande.

En pratique, la sortie du bloc de traitement en tension formant différentiateur est reliée à un bloc intégrateur.

Par exemple, le bloc différentiateur est un amplificateur soustracteur.

Selon une autre réalisation, le dispositif comprend en outre des cinquième et sixième paires de commutateurs à ouverture/fermeture alternée selon les première et seconde phases, disposées en amont des entrées positive et négative de l'amplificateur soustracteur et des moyens de commande propres à commander l'ouverture/fermeture desdites cinquième et sixième paires de commutateurs de manière à relier pendant la première phase la première sortie du bloc de conversion à l'entrée négative et la seconde sortie du bloc de conversion à l'entrée positive et réciproquement pendant la seconde phase.

Par exemple, le bloc intégrateur est un amplificateur actif de type RC.

Selon encore une autre réalisation, le dispositif comprend en outre des septième et huitième paires de commutateurs à ouverture/fermeture alternée selon les première et seconde phases, disposées en amont des entrées positive et négative de l'amplificateur actif et des moyens de commande propres à commander l'ouverture/fermeture desdites septième et huitième paires de commutateurs de manière à relier pendant la première phase la sortie du bloc différenciateur à l'entrée négative de l'amplificateur actif et une tension de référence à l'entrée positive de l'amplificateur actif et réciproquement pendant la seconde phase.

Selon encore une autre réalisation, le bloc de conversion temps-tension symétrique comprend un convertisseur temps-tension du type à pompe de charge différentielle et le bloc de traitement en tension est équipé d'un convertisseur possédant des première et seconde entrées recevant respectivement les première et seconde tensions différentielles à traiter et une sortie délivrant un signal unipolaire.

D'autres caractéristiques et avantages de l'invention apparaîtront à la lumière de la description détaillée ci-après et des dessins dans lesquels :
- la **figure 1,** déjà décrite, illustre un système à boucle de verrouillage de phase de l'art antérieur ;
- la **figure 2,** déjà décrite, représente des chronogrammes des signaux d'horloge du système de la **figure 1 ;**
- la **figure 3,** déjà décrite, illustre schématiquement un convertisseur temps-tension symétrique de type différentiel selon l'art antérieur ;
- la **figure 4,** déjà décrite, illustre schématiquement un système à boucle de verrouillage de phase utilisant un convertisseur temps-tension symétrique de type différentiel de la **figure 3,** selon l'art antérieur ;
- la **figure 5** représente schématiquement un système à boucle de verrouillage de phase utilisant un convertisseur temps-tension symétrique à deux voies élémentaires ;
- la **figure 6** représente schématiquement un système à boucle de verrouillage de phase de la **figure 5,** équipé du dispositif de compensation de l'erreur statique selon l'invention ;
- la **figure 7** liste de manière détaillée un mode de réalisation du dispositif de compensation selon l'invention ;
- la **figure 8** illustre schématiquement un mode de réalisation et les moyens de commande de la compensation d'erreur de phase statique selon l'invention ;
- la **figure 9** illustre des chronogrammes des moyens de commande de la **figure 10 ;**
- la **figure 10** illustre des chronogrammes relatifs à la compensation d'erreur de phase statique selon l'invention ;
- la **figure 11** représente schématiquement un système à boucle de verrouillage de phase du type décrit en référence à la **figure 4** et équipé du dispositif de compensation de l'erreur statique selon l'invention ; et
- la **figure 12** est un schéma bloc d'une architecture de conversion analogique-numérique utilisant un système à boucle de verrouillage de phase selon l'invention.

En référence à la **figure 5,** le système à boucle de verrouillage de phase comprend cinq blocs constitutifs. Le premier bloc est le comparateur de phase PC, le second bloc BE1 est relatif à la conversion temps-tension unipolaire sur deux voies séparées. Le troisième bloc BE2 est relatif à la soustraction des tensions des voies unipolaires. Le quatrième bloc BE3 est relatif à l'intégration de la différence des deux tensions et le cinquième bloc CVDL est la ligne à retards.

Le bloc de conversion BE1 comprend des opérations de commutation de signaux, qui sont réalisées de manière parfaitement symétrique pour les voies séparées, ce qui supprime complètement le désappariement dynamique structurel.

Le bloc de conversion BE1 comprend deux convertisseurs temps-tension élémentaires CTT1 et CTT2, identiques, montés séparément et symétriquement en parallèle. Chaque convertisseur élémentaire CTT1 ou CTT2 comprend une entrée recevant un signal de commande de polarité respectif Up ou Dwn et une sortie délivrant une tension Vup ou Vdwn représentative de la durée de chaque signal de commande.

Une description détaillée de chaque convertisseur temps-tension élémentaire est décrite dans la demande déposée le même jour par le Demandeur et intitulée « Circuit de conversion temps-tension symétrique ».

La conversion temps-tension a lieu de manière symétrique. La différence de tension Vup-Vdwn est réalisée en continu par le bloc BE2. Ce bloc BE2 comprend un amplificateur soustracteur 300 possédant une entrée positive 302 recevant la tension Vup à travers une résistance 306 et une entrée négative 304 recevant la tension Vdwn à travers une résistance 308. Une tension de référence Vref alimente l'entrée positive 302 à travers une résistance 310 et la sortie 330 est reliée à l'entrée négative 304 à travers une résistance 320.

L'intégration de la différence Vdiff est réalisée en continu par un intégrateur BE3 comprenant un amplificateur 400 à montage actif de type résistance 410 et capacité 420.

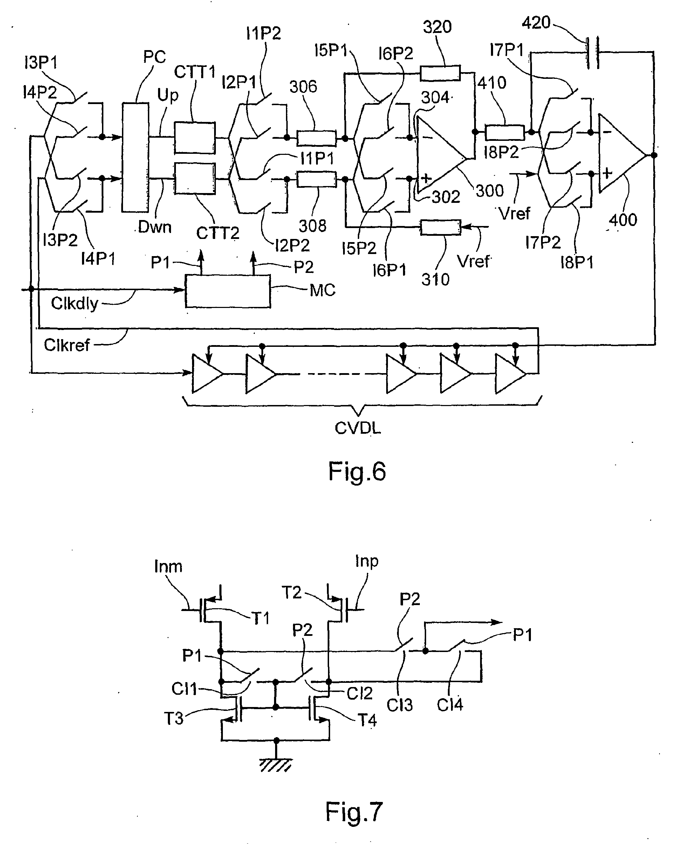

En référence à la **figure 6,** il est prévu d'inverser les voies Clkref/Up et Clkdly/Dwn et à moyenner le résultat de la conversion temps-tension avec l'intégrateur 400 du système à boucle de verrouillage de phase.

Pour assurer un fonctionnement correct de la boucle, il est aussi nécessaire d'inverser la polarité du signal de commande de la ligne à retards commandés à chaque inversion des voies Clkref/Up et Clkdly/Dwn.

Le basculement d'une voie sur l'autre est réalisé par commutations de *switchs,* ou commutateurs.

En pratique, le dispositif comprend des première I1P1 et I1P2 et seconde 12P1 et 12P2 paires de commutateurs à ouverture/fermeture alternée selon des première et seconde phases P1 et P2, intercalées entre les première et seconde sorties du bloc de conversion temps-tension symétrique d'une part et les première et seconde entrées du bloc de traitement en tension d'autre part.

Des commutateurs sont en outre disposés en amont du comparateur de phase PC. Dans cette réalisation, le dispositif comprend des troisième I3P1 et 13P2 et quatrième I4P1 et I4P2 paires de commutateurs à ouverture/fermeture alternée selon les première et seconde phases P1 et P2, disposées en amont des première et seconde entrées du comparateur de phase PC.

Les moyens de commande MC commandent l'ouverture/fermeture des première à quatrième paires de commutateurs de manière à relier pendant la première phase P1 le premier signal d'horloge Clkref sur la première entrée du comparateur et le second signal d'horloge Clkdly sur la seconde entrée du comparateur et la première sortie du bloc de conversion à la seconde entrée du bloc de traitement et la seconde sortie du bloc de conversion à la première entrée du bloc de traitement et pendant la seconde phase P2 le premier signal d'horloge Clkref sur la seconde entrée du comparateur et le second signal d'horloge Clkdly sur la première entrée du comparateur et la première sortie du bloc de conversion à la première entrée du bloc de traitement et la seconde sortie du bloc de conversion à la seconde entrée du bloc de traitement.

On peut noter que la phase P1 en référence à la **figure 6** correspond au fonctionnement du système à boucle de verrouillage de phase décrit en référence à la **figure 5**.

La phase P2 correspond à un fonctionnement dans lequel la voie Clkref/Up prend la place de la voie Clkdly/Dwn et réciproquement.

Dans les deux phases P1 et P2, on réalise toujours rigoureusement la différence Vup-Vdwn sur le différenciateur BE2 de manière à garder la fonctionnalité du système à boucle de verrouillage de phase.

Ainsi, l'erreur ou désappariement entre les deux voies se retrouve après le différenciateur BE2 avec un signe opposé d'une phase sur l'autre.

Par exemple, si on suppose que le désappariement entres les deux voies donne lieu à une erreur Ve, on a :
- en phase P1, la sortie du différenciateur est (Vup+Ve)-Vdwn=(Vup-Vdwn)+Ve ; et
- en phase P2, la sortie du différenciateur est Vup-(Vdwn+Ve)=(Vup-Vdwn)-Ve.

Après filtrage par l'intégrateur, l'erreur résiduelle crête à crête théorique est : Vres_{cc}=Ve*π*fint/fcomp, avec fint : fréquence de coupure de l'intégrateur BE3 et fcomp : fréquence de la boucle de compensation.

Par exemple, si la fréquence de l'intégrateur est fixée à 100kHz et la fréquence de la compensation est fixée à 10MHz, on a Vres_{cc}=Ve/31, soit une réduction d'un facteur 31 sur l'erreur initiale Ve.

Avantageusement, le décalage ou *offset* dû au désappariement des transistors constituant la paire différentielle d'entrée des amplificateurs (A1) 300 et (A2) 400 est compensé sur le même principe. Le décalage ou *offset* est appliqué alternativement en positif ou en négatif sur les sorties des amplificateurs, le résultat est moyenné par l'intégrateur 400.

Ainsi, le dispositif comprend des cinquième I5P1 et 15P2 et sixième I6P1 et 16P2 paires de commutateurs à ouverture/fermeture alternée selon les première et seconde phases P1 et P2, disposées en amont des entrées positive et négative de l'amplificateur soustracteur 300.

Les moyens de commande MC commandent l'ouverture/fermeture des commutateurs de manière à relier pendant la première phase P1 la première sortie du bloc de conversion à l'entrée négative et la seconde sortie du bloc de conversion à l'entrée positive et réciproquement pendant la seconde phase P2.

Selon une autre réalisation, le dispositif comprend en outre des septième I7P1, 17P2 et huitième I8P1, I8P2 paires de commutateurs à ouverture/fermeture alternée selon les première et seconde phases P1 et P2, disposées en amont des entrées positive et négative de l'amplificateur actif 400.

Les moyens de commande MC commandent l'ouverture/fermeture des commutateurs de manière à relier pendant la première phase P1 la sortie du bloc différenciateur à l'entrée négative de l'amplificateur actif et une tension de référence. Vref à l'entrée positive de l'amplificateur actif et réciproquement pendant la seconde phase P2.

En référence à la **figure 7,** on a décrit un exemple de réalisation d'un amplificateur A (300 ou 400) comprenant quatre transistors T1 à T4 et équipé des moyens de compensation conformes à l'invention.

La réalisation de la compensation comprend quatre commutateurs CI1 à CI4 internes. Les commutateurs CI1 et CI2 permettent d'échanger les entrées Inp et Inm à une fréquence choisie. Ainsi, l'entrée Inp devient Inm et réciproquement. Des commutateurs CI3 et CI4 positionnés en entrée des amplificateurs permettent de rétablir les connexions avec les éléments externes, c'est-à-dire les résistances et les capacités (non représentées) de l'amplificateur.

Pour générer les horloges de commande des commutateurs dans les phases P1 et P2 à la fréquence de compensation voulue, on peut par exemple utiliser l'horloge d'entrée Clkref, divisée par une série de bascules D, individualisées en D1 à D7, et rebouclées en diviseur par 2.

Le bloc doit générer les horloges basse fréquence P1 et P2 à partir de l'horloge de référence haute fréquence Clkref. En particulier, l'horloge de référence du système Clkref est divisée par un coefficient qui est une puissance de 2.

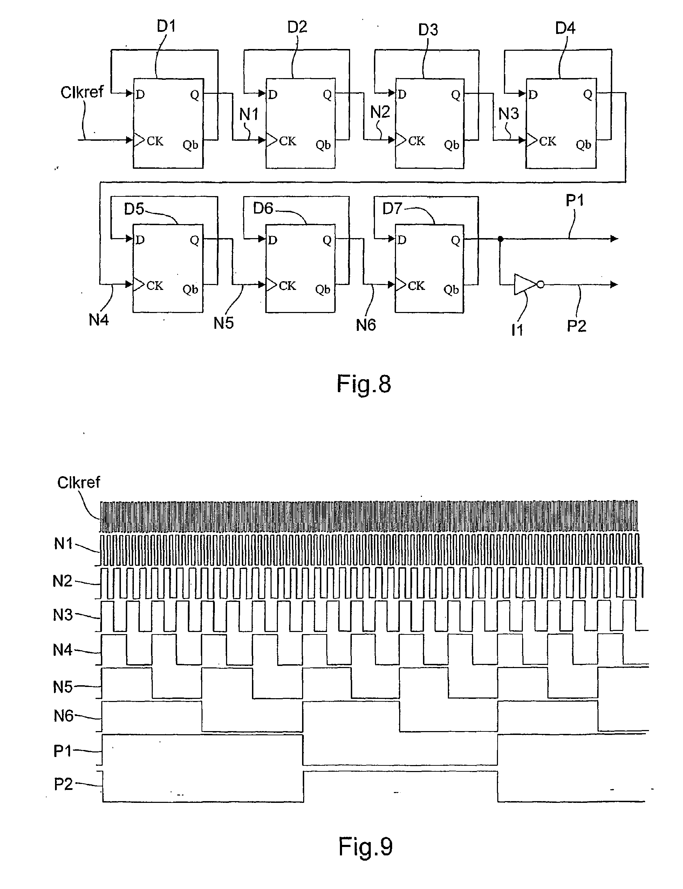

Par exemple **(figures 8** et **9),** si l'on réalise l'enchaînement de 7 bascules à front (D1 à D7) bouclée en diviseur par 2, le signal N1 est de fréquence FClkref/2, le signal N2 est de fréquence FClkref/4, le signal N3 est de fréquence FClkref/8, le signal N4 est de fréquence FClkref/16, le signal N5 est de fréquence FClkref/32, le signal N6 est de fréquence FClkref/64.

Les commandes des phases P1 et P2 sont donc des horloges de fréquence FClkref/128.

L'horloge P2 générée par l'inverseur I1 est le complémentaire de l'horloge P1.

Dans la bascule à front, la sortie Qb est le complémentaire de la sortie Q.

Par exemple, avec Fclkref égale à 1.25GHz, on obtient une fréquence de compensation de l'erreur de phase statique de 9.77MHz.

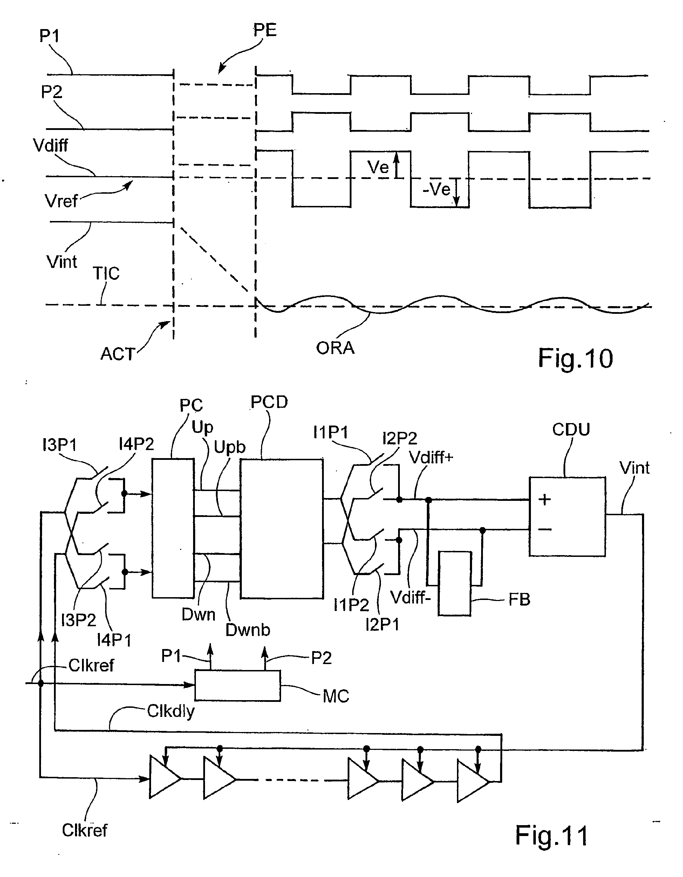

En référence à la **figure 10,** on a décrit des chronogrammes illustrant la compensation d'erreur de phase statique.

Lorsque la compensation de l'erreur de phase statique n'est pas activée, on voit que la tension Vint se positionne de sorte que les décalages entre les horloges Clkref et Clkdly compense l'erreur Ve, c'est-à-dire que la sortie du différenciateur Vdiff soit exactement à la valeur Vref. Dans l'exemple proposé, Vint est au-dessus de la tension idéale de commande (TIC) de la ligne à retard, c'est-à-dire la valeur qui donne le délai correct.

Lorsque la compensation est activée (ACT) et en mode établi (après la période d'établissement PE), la sortie du différenciateur Vdiff va être alternativement entachée d'une erreur Ve et -Ve. Si la fréquence de compensation n'est pas trop petite devant la bande passante de la boucle de la DLL, alors la tension Vdiff n'a pas le temps de se repositionner à la valeur Vref.

La tension Vint se trouve ainsi "en moyenne" à la valeur idéale de commande de la ligne à retard. L'ondulation résiduelle (ORA) obtenue en mode de compensation dépend de l'amplitude de l'erreur (Ve), de la fréquence de compensation (fcomp) et de la bande passante de la DLL (fint).

En référence à la **figure 11,** on a représenté le système à boucle de verrouillage de phase de la **figure 4,** équipé du dispositif de compensation de l'erreur statique selon l'invention.

Les tensions différentielles Vdiff+ et Vdiff- issues de la conversion temps-tension effectuée par le pompe de charge PCD et intégrées par le filtre de boucle FB, sont converties en une tension Vint unipolaire par le bloc de conversion différentiel vers unipolaire CDU.

Le principe de fonctionnement de la compensation de l'erreur de phase statique est le même que celui décrit précédemment en référence aux **figures 5** à **10** pour l'architecture à base de conversion temps-tension symétrique.

La boucle de compensation permet de compenser les erreurs dans le comparateur de phase PC et le pompe de charge différentielle PCD.

Le basculement d'une voie sur l'autre est réalisé par commutation des paires de commutateurs I1P1, I2P2, I1P2 et I2P1 et des paires de commutateurs I3P1, 14P2, 13P2 et I4P1 sous la commande des moyens de commande MC. On peut noter que la phase P1 sur le système décrit en référence à la **figure 11** correspond au fonctionnement du système à boucle de verrouillage de phase selon le schéma de la **figure 4.** La phase P2 correspond à un fonctionnement dans lequel la voie Clkref/Up prend la place de la voie Clkdly/Dwn et réciproquement.

Les signaux des voies Clkref/Up et Clkdly/Dwn sont remis dans la bonne polarité avant le filtre de boucle FB intégrateur, de manière à garder la fonctionnalité du système à boucle de verrouillage de phase.

La logique de contrôle MC consiste à générer des signaux pour les phases P1 et P2.

Pour générer les horloges de commande des commutateurs dans les phases P1 et P2 à la fréquence de compensation voulue, on peut utiliser l'horloge d'entrée Clkref divisée par une série de bascules D rebouclées en diviseur par 2.

Ainsi, la présente invention propose une compensation de l'erreur de phase statique sans ajouter de composants susceptibles d'introduire des erreurs supplémentaires. Les seuls composants ajoutés sont des commutateurs constitués de transistors de taille réduite et une logique de contrôle.

La présente invention permet de compenser non seulement des erreurs de désappariement dans la conversion temps-tension, mais aussi les désappariements dans le comparateur de phase car ce dernier est également réalisé de manière symétrique.

Le bloc de compensation selon l'invention est simple à réaliser et ne nécessite pas de précaution particulière dans la mise en oeuvre car la boucle supplémentaire n'apporte pas d'instabilité dans la boucle principale du système à boucle de verrouillage de phase.

De plus, il est possible de contrôler le niveau de compensation en modifiant la fréquence de coupure de l'intégrateur et/ou la fréquence d'activation de la boucle de compensation.

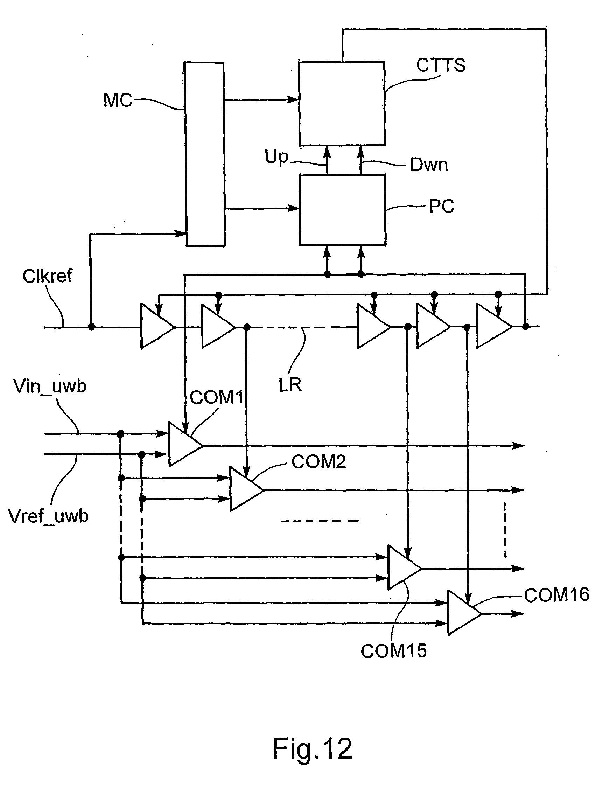

En référence à la **figure 12,** la présente invention trouve une application dans l'architecture de conversion d'un système fonctionnant en Ultra Large Bande (ULB ou UWB), dans lequel on numérise sur 1 bit un signal UWB à la fréquence de 20GHz.

Pour des raisons de limitation technologique, la conversion 1 bit à 20GHz est effectuée à plus basse fréquence. On génère par exemple 16 horloges à la fréquence de 1,25GHz, décalée de 50ps. On obtient ainsi un convertisseur analogique-numérique 1 bit fonctionnant à 20GHz (50ps) constitué de 16 comparateurs montés en parallèle et commandés par 16 horloges décalées.

Une boucle à asservissement de phase (DLL) a pour objet de contrôler le délai ou le décalage de 50ps et de générer les 16 horloges.

Le signal analogique à convertir est Vin_uwb. Il est comparé à une tension Vref_uwb grâce à 16 comparateurs COM individualisés COM1 à COM16 positionnés en parallèle. Les comparateurs COM sont activés à la fréquence de 1,25GHz en décalage de 50ps. Les résultats des 16 conversions sont envoyés sur un bloc logique pour la remise en forme et l'exploitation.

Les 16 horloges décalées de 50ps sont générées par le système à boucle de verrouillage de phase conforme à l'invention et constitué d'une ligne à retards commandés en tension LR, d'un comparateur de phase PC et d'un convertisseur temps-tension symétrique CTTS apportant la meilleure précision.

Les moyens de compensation articulés autour des moyens de commutation formés de paires de commutateurs et de la logique de commande associée MC sont intégrés dans le système à boucle de verrouillage de phase et permettent d'améliorer la précision du système à la fréquence de fonctionnement de 1,25GHz.

## Revendications

1. Dispositif à boucle de verrouillage de phase comprenant un comparateur de phase (PC) possédant des première et seconde entrées recevant respectivement des premier et second signaux d'horloge (Clkref et Clkdly) et des première et seconde sorties délivrant respectivement des premier et second signaux logiques (Up et Dwn), un bloc de conversion temps-tension symétrique possédant au moins des première et seconde entrées recevant respectivement les premier et second signaux logiques (Up et Dwn) et des première et seconde sorties délivrant respectivement une tension (Vup, Vdwn, Vdiff+ et Vdiff-) fonction des premier et/ou second signaux logiques (Up et Dwn), et un bloc de traitement en tension possédant des première et seconde entrées recevant respectivement des première et seconde tensions à traiter (Vup, Vdwn, Vdiff+ et Vdiff-), **caractérisé en ce qu'**il comprend en outre des première (I1P1 et I1P2) et seconde (I2P1 et I2P2) paires de commutateurs à ouverture/fermeture alternée selon des première et seconde phases (P1 et P2), intercalées entre les première et seconde sorties du bloc de conversion temps-tension symétrique d'une part et les première et seconde entrées du bloc de traitement en tension d'autre part, des troisième (I3P1 et I3P2) et quatrième (I4P1 et I4P2) paires de commutateurs à ouverture/fermeture alternée selon les première et seconde phases (P1 et P2), disposées en amont des première et seconde entrées du comparateur de phase (PC), et des moyens de commande propres à commander l'ouverture/fermeture des première à quatrième paires de commutateurs de manière à relier pendant la première phase (P1) le premier signal d'horloge (Clkref) sur la première entrée du comparateur et le second signal d'horloge (Clkdly) sur la seconde entrée du comparateur et la première sortie du bloc de conversion à la seconde entrée du bloc de traitement et la seconde sortie du bloc de conversion à la première entrée du bloc de traitement et pendant la seconde phase (P2) le premier signal d'horloge (Clkref) sur la seconde entrée du comparateur et le second signal d'horloge (Clkdly) sur la première entrée du comparateur et la première sortie du bloc de conversion à la première entrée du bloc de traitement et la seconde sortie du bloc de conversion à la seconde entrée du bloc de traitement.

2. Dispositif selon la revendication 1, dans lequel il est prévu en outre une ligne à retards commandés en tension (CVDL) possédant une première entrée recevant le signal de sortie (Vint) du dispositif à boucle de verrouillage de phase, une seconde entrée recevant le premier signal d'horloge (Clkref) et une sortie délivrant le second signal d'horloge (Clkdly).

3. Dispositif selon la revendication 1, dans lequel le bloc de conversion temps-tension comprend deux convertisseurs temps-tension élémentaires (CTT1 et CTT2), structurellement identiques l'un par rapport à l'autre, et possédant chacun une entrée recevant un signal de commande logique respectif (Up et Dwn) et une sortie délivrant une tension représentative de la durée du signal de commande logique (Vup, Vdwn) correspondant.

4. Dispositif selon la revendication 3, dans lequel le bloc de traitement en tension comprend un bloc différentiateur (BE2) possédant des entrées positive (302) et négative (304) reliées chacune à une sortie d'un convertisseur élémentaire associé (CTT1 et CTT2) via les première et seconde paires de commutateurs (I1P1,I1P2 et I2P1,I2P2) et une sortie délivrant un signal (Vdiff) représentatif de la différence de tension entre les deux signaux de commande (Up et Dwn).

5. Dispositif selon la revendication 4, dans lequel la sortie du bloc différentiateur est reliée à un bloc intégrateur (BE3).

6. Dispositif selon la revendication 4, dans lequel le bloc différentiateur (BE2) est un amplificateur soustracteur (300).

7. Dispositif selon la revendication 6, dans lequel il est prévu en outre des cinquième (I5P1, et I5P2) et sixième (I6P1 et I6P2) paires de commutateurs à ouverture/fermeture alternée selon les première et seconde phases (P1 et P2), disposées en amont des entrées positive et négative de l'amplificateur soustracteur (300) et des moyens de commande propres à commander l'ouverture/fermeture desdites cinquième et sixième paires de commutateurs de manière à relier pendant la première phase (P1) la première sortie du bloc de conversion à l'entrée négative et la seconde sortie du bloc de conversion à l'entrée positive et réciproquement pendant la seconde phase (P2).

8. Dispositif selon la revendication 5 dans lequel le bloc intégrateur (BE3) est un amplificateur (400) actif de type RC.

9. Dispositif selon la revendication 8, dans lequel il est prévu en outre des septième (I7P1, I7P2) et huitième (I8P1, I8P2) paires de commutateurs à ouverture/fermeture alternée selon les première et seconde phases (P1 et P2), disposées en amont des entrées positive et négative de l'amplificateur actif (400) et des moyens de commande propres à commander l'ouverture/fermeture desdites septième et huitième paires de commutateurs de manière à relier pendant la première phase (P1) la sortie du bloc différenciateur à l'entrée négative de l'amplificateur actif et une tension de référence (Vref) à l'entrée positive de l'amplificateur actif et réciproquement pendant la seconde phase (P2).

10. Dispositif selon la revendication 1, dans lequel le bloc de conversion temps-tension comprend un convertisseur temps-tension du type à pompe de charge différentielle (PCD) et le bloc de traitement en tension est équipé d'un convertisseur (CDU) possédant des première et seconde entrées recevant respectivement des première et seconde tensions différentielles (Vdiff+ et Vdiff-) à traiter et une sortie délivrant un signal unipolaire (Vint).

## Claims

1. Phase-locked loop device including a phase comparator (PC) having first and second inputs respectively receiving first and second clock signals (Clkref and Clkdly) and first and second outputs respectively delivering first and second logic signals (Up and Dwn), a symmetrical time-voltage conversion block having at least first and second inputs respectively receiving the first and second logic signals (Up and Dwn) and first and second outputs respectively delivering a voltage (Vup, Vdwn, Vdiff+ and Vdiff-) as a function of the first and/or second logic signals (Up and Dwn), and a voltage processing block having first and second inputs respectively receiving first and second voltages to be processed (Vup, Vdwn, Vdiff+ and Vdiff-), **characterized in that** it further includes a first pair of switches (I1P1 and I1P2) and a second pair of switches (I2P1 and I2P2) opened/closed alternately in accordance with first and second phases (P1 and P2), interleaved between the first and second outputs of the symmetrical time-voltage conversion block, on the one hand, and the first and second inputs of the voltage processing block, on the other hand, a third pair of switches (I3P1 and I3P2) and a fourth pair of switches (I4P1 and I4P2) opened/closed alternately in accordance with the first and second phases (P1 and P2), disposed on the upstream side of the first and second inputs of the phase comparator (PC), and control means for controlling opening/closing of the first to fourth pairs of switches in such a manner as to connect during the first phase (P1) the first clock signal (Clkref) to the first input of the comparator and the second clock signal (Clkdly) to the second input of the comparator and the first output of the conversion block to the second input of the processing block and the second output of the conversion block to the first input of the processing block and during the second phase (P2) the first clock signal (Clkref) to the second input of the comparator and the second clock signal (Clkdly) to the first input of the comparator and the first output of the conversion block to the first input of the processing block and the second output of the conversion block to the second input of the processing block.

2. Device according to claim 1, wherein there is further provided a voltage-controlled delay line (CVDL) having a first input receiving the output signal (Vint) of the phase-locked loop device, a second input receiving the first clock signal (Clkref) and an output delivering the second clock signal (Clkdly).

3. Device according to claim 1, wherein the time-voltage conversion block includes two structurally identical basic time-voltage converters (CTT1 and CTT2) each having an input receiving a respective logic control signal (Up and Dwn) and an output delivering a voltage representative of the duration of the corresponding logic control signal (Vup, Vdwn).

4. Device according to claim 3, wherein the voltage processing block includes a differentiator block (BE2) having a positive input (302) and a negative input (304) each connected to an output of an associated basic converter (CTT1 and CTT2) via the first and second pairs of switches (I1P1, I1P2 and I2P1, I2P2) and an output delivering a signal (Vdiff) representative of the voltage difference between the two control signals (Up and Dwn).

5. Device according to claim 4, wherein the output of the differentiator block is connected to an integrator block (BE3).

6. Device according to claim 4, wherein the differentiator block (BE2) is a subtractor amplifier (300).

7. Device according to claim 6, wherein there are further provided a fifth pair of switches (I5P1 and I5P2) and a sixth pair of switches (I6P1 and I6P2) opened/closed alternately in accordance with the first and second phases (P1 and P2), disposed on the upstream side of the positive and negative inputs of the subtractor amplifier (300) and control means for controlling opening/closing of said fifth and sixth pairs of switches in such a manner as to connect during the first phase (P1) the first output of the conversion block to the negative input and the second output of the conversion block to the positive input and vice-versa during the second phase (P2).

8. Device according to claim 5 wherein the integrator block (BE3) is an active amplifier (400) of RC type.

9. Device according to claim 8, wherein there are further provided a seventh pair of switches (I7P1, I7P2) and an eighth pair of switches (I8P1, I8P2) opened/closed alternately in accordance with the first and second phases (P1 and P2), disposed on the upstream side of the positive and negative inputs of the active amplifier (400) and control means for controlling opening/closing of said seventh and eighth pairs of switches in such a manner as to connect during the first phase (P1) the output of the differentiator block to the negative input of the active amplifier and a reference voltage (Vref) to the positive input of the active amplifier and vice-versa during the second phase (P2).

10. Device according to claim 1, wherein the time-voltage conversion block includes a time-voltage converter of the differential charge pump (PCD) type and the voltage processing block is equipped with a converter (CDU) having first and second inputs respectively receiving first and second differential voltages (Vdiff+ and Vdiff-) to be processed and an output delivering a unipolar signal (Vint).

## Patentansprüche

1. Vorrichtung mit Phasenverriegelungsschleife, umfassend einen Phasenvergleicher (PC), der einen ersten und einen zweiten Eingang, die ein erstes bzw. ein zweites Zeitgebersignal (Clkref und Clkdly) empfangen, und einen ersten und einen zweiten Ausgang besitzt, die ein erstes bzw. ein zweites logisches Signal (Up und Dwn) liefern, einen symmetrischen Zeit-Spannungs-Umwandlungsblock, der mindestens einen ersten und einen zweiten Eingang, der das erste bzw. das zweite logische Signal (Up und Dwn) empfängt, und einen ersten und einen zweiten Ausgang besitzt, die jeweils eine Spannung (Vup, Vdwn, Vdiff+ und Vdiff-) in Abhängigkeit von dem ersten und/oder dem zweiten logischen Signal (Up und Dwn) liefern, und einen Spannungsbehandlungsblock, der einen ersten und einen zweiten Eingang besitzt, die eine erste bzw. eine zweite zu behandelnde Spannung (Vup, Dwn, Vdiff+ und Vdiff-) empfangen, **dadurch gekennzeichnet, dass** sie außerdem umfasst: ein erstes (I1P1 und I1P2) und ein zweites (I2P1 und I2P2) Paar von Schaltern mit abwechselnder Öffnung/Schließung gemäß einer ersten und einer zweiten Phase (P1 und P2), die zwischen den ersten und den zweiten Ausgang des symmetrischen Zeit-Spannungs-Umwandlungsblocks einerseits und den ersten und den zweiten Eingang des Spannungsbehandlungsblocks andererseits eingesetzt sind, ein drittes (I3P1 und I3P2) und ein viertes (I4P1 und I4P2) Paar von Schaltern mit abwechselnder Öffnung / Schließung gemäß einer ersten und einer zweiten Phase (P1 und P2), die stromauf des ersten und des zweiten Eingangs des Phasenvergleichers (PC) angeordnet sind, und Steuermittel, die geeignet sind, die Öffnung/ Schließung des ersten bis vierten Paars von Schaltern so zu steuern, dass während der ersten Phase (P1) das erste Zeitgebersignal (Clkref) auf den ersten Eingang des Vergleichers und das zweite Zeitgebersignal (Clkdly) auf den zweiten Eingang des Vergleichers und der erste Ausgang des Umwandlungsblocks mit dem zweiten Eingang des Behandlungsblocks und der zweite Ausgang des Umwandlungsblocks mit dem ersten Eingang des Behandlungsblocks und während der zweiten Phase (P2) das erste Zeitgebersignal (Clkref) auf dem zweiten Eingang des Vergleichers und das zweite Zeitgebersignal (Clkdly) auf dem ersten Eingang des Vergleichers und der erste Ausgang des Umwandlungsblocks mit dem ersten Eingang des Behandlungsblocks und der zweite Ausgang des Umwandlungsblocks mit dem zweiten Eingang des Behandlungsblocks verbunden wird.

2. Vorrichtung nach Anspruch 1, bei der außerdem eine Strecke mit spannungsgesteuerten Verzögerungen (CVDL) vorgesehen ist, die einen ersten Eingang, der das Ausgangssignal (Vint) der Vorrichtung mit Phasenverriegelungsschleife empfängt, einen zweiten Eingang, der das erste Zeitgebersignal (Clkref) empfängt, und einen Ausgang besitzt, der das zweite Zeitgebersignal (Clkdly) liefert.

3. Vorrichtung nach Anspruch 1, bei der der Zeit-Spannungs-Umwandlungsblock zwei Einzel-Zeit-Spannungs-Wandler (CTT1 und CTT2) umfasst, die strukturell miteinander identisch sind und jeweils einen Eingang, der ein jeweiliges logisches Steuersignal (Up und Dwn) empfängt, und einen Ausgang besitzen, der eine Spannung liefert, die für die Dauer des entsprechenden logischen Steuersignals (Vup, Vdwn) repräsentativ ist.

4. Vorrichtung nach Anspruch 3, bei der der Spannungsbehandlungsblock einen Differenzierblock (BE2) umfasst, der einen positiven Eingang (302) und einen negativen Eingang (304), die jeweilig mit einem Ausgang eines zugeordneten Einzelwandlers (CTT1 und CTT2) über das erste und das zweite Paar von Schaltern (I1P1, I1P2 und I2P1, I2P2) verbunden sind, und einen Ausgang besitzt, der ein Signal (Vdiff) liefert, das für die Spannungsdifferenz zwischen den beiden Steuersignalen (Up und Dwn) repräsentativ ist.

5. Vorrichtung nach Anspruch 4, bei der der Ausgang des Differenzierblocks mit einem Integrierblock (BE3) verbunden ist.

6. Vorrichtung nach Anspruch 4, bei der der Differenzierblock (BE2) ein Subtrahierverstärker (300) ist.

7. Vorrichtung nach Anspruch 6, bei der außerdem ein fünftes (I5P1 und I5P2) und ein sechstes (I6P1 und P6P2) Paar von Schaltern mit abwechselnder Öffnung/ Schließung gemäß der ersten und der zweiten Phase (P1 und P2), die stromauf des positiven und des negativen Eingangs des Substrahierverstärkers (300) angeordnet sind, und Steuermittel vorgesehen sind, die geeignet sind, die Öffnung/Schließung dieses fünften und sechsten Paars von Schaltern so zu steuern, dass während der ersten Phase (P1) der erste Ausgang des Umwandlungsblocks mit dem negativen Eingang und der zweite Ausgang des Umwandlungsblocks mit dem positiven Eingang und umgekehrt während der zweiten Phase (P2) verbunden wird.

8. Vorrichtung nach Anspruch 5, bei der der Integrierblock (BE3) ein aktiver RC-Verstärker (400) ist.

9. Vorrichtung nach Anspruch 8, bei der außerdem ein siebtes (I7P1, I7P2) und ein achtes (I8P1, I8P2) Paar von Schaltern mit abwechselnder Öffnung/ Schließung gemäß der ersten und der zweiten Phase (P1 und P2), die stromauf des positiven und des negativen Eingangs des aktiven Verstärkers (400) angeordnet sind, und Steuermittel vorgesehen sind, die geeignet sind, die Öffnung/ Schließung des siebten und achten Paars von Schaltern so zu steuern, dass während der ersten Phase (P1) der Ausgang des Differenzierblocks mit dem negativen Eingang des aktiven Verstärkers und eine Bezugsspannung (Vref) mit dem positiven Eingang des aktiven Verstärkers und umgekehrt während der zweiten Phase (P2) verbunden wird.

10. Vorrichtung nach Anspruch 1, bei der der Zeit-Spannungs-Umwandlungsblock einen Zeit-Spannungs-Wandler vom Typ mit Differentialladungspumpe (PCD) umfasst und der Spannungsbehandlungsblock mit einem Wandler (CDU) ausgerüstet ist, der einen ersten und einen zweiten Eingang, die eine erste bzw. eine zweite zu behandelnde Differentialspannung (Vdiff+ und Vdiff-) emmpfangen, und einen Ausgang besitzt, der ein einpoliges Signal (Vint) liefert.
